Europäisches Patentamt

European Patent Office

Office européen des brevets

(11) Publication number: **0 296 401 B1**

## EUROPEAN PATENT SPECIFICATION

(45) Date of publication of patent specification: **18.11.93**   (51) Int. Cl.⁵: **C01B 33/12**, C01B 33/152

(21) Application number: **88109049.2**

(22) Date of filing: **07.06.88**

(54) **Process for manufacturing fine silica particles.**

(30) Priority: **09.06.87 JP 142167/87**
**22.04.88 JP 98184/87**

(43) Date of publication of application:
**28.12.88 Bulletin 88/52**

(45) Publication of the grant of the patent:
**18.11.93 Bulletin 93/46**

(84) Designated Contracting States:
**BE DE ES FR GB IT NL**

(56) References cited:
**EP-A- 0 206 353**

**PATENT ABSTRACTS OF JAPAN, vol. 1, no.
4, 10th March 1977, page 95 C 76; & JP-A-51
112 924 (ASAHI KASEI KOGYO K.K.)
05-10-1976**

(73) Proprietor: **NITTO CHEMICAL INDUSTRY CO.,
LTD.**
**No. 5-1, Marunouchi 1-chome**
**Chiyoda-ku**
**Tokyo(JP)**

Proprietor: **MITSUBISHI RAYON CO., LTD.**
**3-19, Kyobashi 2-chome**
**Chuo-Ku**
**Tokyo 104(JP)**

(72) Inventor: **Orii, Koichi**
**8-904, Wakabadai-2-chome**
**Asahi-ku Yokohama(JP)**
Inventor: **Yagi, Junsuke**
**63-6, Minamihonjukucho**
**Asahi-ku Yokohama(JP)**
Inventor: **Oshima, Iwao**
**10-1-108, Ichiba Kamicho**
**Tsurumi-ku Yokohama(JP)**

(74) Representative: **Hansen, Bernd, Dr.rer.nat. et
al**
**Hoffmann, Eitle & Partner,**
**Patentanwälte,**
**Postfach 81 04 20**
**D-81904 München (DE)**

**EP 0 296 401 B1**

**Description**

FIELD OF THE INVENTION AND RELATED ART STATEMENT

This invention relates to a process for manufacturing fine silica particles. Particularly, it relates to a process for manufacturing fine silica particles containing substantially no coarse particle and having a controlled particle size distribution which comprises grinding hollow silica fibers having a wall thickness smaller than the particle size of coarse particles to be removed.

The silica particles obtained by the process of this invention can be suitably used as a filler, particularly as a filler for resin compositions for encapsulating electronic parts.

DESCRIPTION OF RELATED ART

As fillers for resin compositions for encapsulating electronic parts, various inorganic substances such as silica are used. It is considered to be advantageous to incorporate the inorganic fillers as much as the moldability permits from the viewpoint of physical properties such as expansion coefficient, thermal conductivity, moisture resistance, and mechanical properties and cost, and silica is considered to be most preferable among the various inorganic substances because it is well balanced among the above-mentioned 1 characteristics and entails only a small cost.

EP-A-0 206 353 discloses high purity silica which is used as a filler for resin compositions for encapsulating electronic parts. The high purity silica has a very low content of impurities. An aqueous alkali silicate solution is used as a starting material which is made into a fine fibrous gel in a coagulant. The obtained fibrous gel is treated with an acid-containing solution and then with water to extract and remove impurities therefrom. Silica particles having a particle size in the range of 1 to 100 $\mu$m can be obtained.

In recent years, with a reduction of the size of elements of electronic parts and an enhancement of the degree of integration of the elements, the size of the elements is extremely reduced, and silica particles having as small a particle size as possible are desired because silica particles as filler for resin compositions for encapsulation, in particular, silica particles having a large particle size tend to injure a fine pattern or a wire in the elements. On the other hand, employment of silica particles having a small average particle size as a filler for resin compositions for encapsulation is disadvantageous in that it is difficult to obtain a good molded product because the employment lowers the fluidity at the time of molding.

For these reasons, there are desired silica particles having a small maximum particle size and as large an average particle size as possible. For example, in Jap. Pat. Appln. Kokai (Laid-Open) No. 59-22955, a resin composition for encapsulating semiconductors is proposed which is obtained by use of silica particles having a maximum particle size of 80 $\mu$m and an average particle size of 25 to 35 $\mu$m. However, no concrete method for preparing silica particles having such a particle size distribution is disclosed therein.

For obtaining silica particles having a particle size distribution suitable for each purpose, for example, for use as a filler, there is usually employed a method comprising grinding starting silica by means of a suitable grinding apparatus while controlling the conditions variously, and if necessary, a classification procedure combined therewith.

Coarse particles are refined usually by intensifying the grinding conditions. In the case of such a method, when the particle size before grinding is large, the particle size distribution of particles obtained by grinding tends to become wide and these particles have too small an average particle size, like conventionally obtained silica.

On the other hand, for removing coarse particles, there is a method in which particles having a particle size larger than a predetermined length are removed by a classification procedure, but this method is disadvantageous in that complete removal of the particles having a particle size larger than the predetermined particle size is difficult and that the method entails great cost.

Recently, there has been a growing demand for silica particles having a maximum particle size smaller than 80 $\mu$m as a filler for resin compositions for encapsulation.

SUMMARY OF THE INVENTION

An object of this invention is to provide a process for manufacturing silica particles having a small maximum particle size and a relatively large average particle size efficiently and economically without classification treatment, in order to satisfy the above-mentioned demand.

2

DETAILED DESCRIPTION OF PREFERRED EMBODIMENT

The gist of this invention consists in a process for manufacturing fine silica particles having an average particle size of 7 to 20 $\mu$m and containing 0.5% by weight or less of coarse particles having a particle size of more than 74 $\mu$m by performing a grinding step by the use of hollow silica fibers having a wall thickness smaller than 74 $\mu$m as the starting material.

The term "particle size" in the present specification means the diameter of particle in the case of spherical particles, or the major axis of particle in the case of non-spherical particles.

The employment, as a starting material for grinding, of hollow fibrous silica having a hollow structure in which a hollow is enclosed with a thin wall, is advantageous in that the maximum particle size of the resulting ground product easily becomes smaller than the wall thickness of the starting material used and the distance between cracks present in the wall surface of hollow, so that grinding of the material requires only low energy.

Therefore, according to the process of this invention, mild grinding conditions can be employed, and moreover fine silica particles having a small maximum particle size, a relatively large average particle size, and a narrow particle size distribution can be obtained without a classification procedure.

As to the particle size of the fine silica particles obtained by the process of this invention, their average particle size is 7 to 20 $\mu$m (for example, 10 $\mu$m), and the content of coarse particles (hereinafter referred to as "grits") having a particle size larger than a certain defined length (for example 44 $\mu$m) can be adjusted to 0.5% by weight or less, if necessary, 0.3% by weight or less, further 0.1% by weight or less.

Said length is more than 74 $\mu$m and the step of grinding is carried out to obtain an average particle size of the fine silica particles in a range of 15 to 20 $\mu$m. According to another embodiment said length is more than 44 $\mu$m and the step of grinding is carried out, so that the average particle size of the fine silica particles is in the range of 10 to 12 $\mu$m.

The hollow fibrous silica used as a starting material for grinding in this invention can be obtained by the process disclosed in USP No. 4,683,128 which the present inventors et al have previously proposed.

One embodiment of this process is as follows.

An aqueous solution of an alkali silicate shown by the general formula $M_2O \bullet nSiO_2$ wherein M is an alkali metal element and n is a number of moles of $SiO_2$ of 0.5 to 5, and having a viscosity in the range of 2 to 500 poise is extruded into a coagulating bath comprising a water-soluble organic medium or an acid solution having a concentration of 4N or less through a nozzle having a bore diameter of 0.2 mm or less to be coagulated in fibrous form, and the fibrous gel thus obtained is treated with an acid-containing solution and then washed with water to extract and remove impurities. In the manner described above or by heat-treating the thus obtained silica at a temperature of 1,000 °C or higher, the hollow fibrous silica used as a starting material for grinding in this invention can be obtained.

By the above-mentioned method, high purity silica can be obtained which has a wall thickness smaller than the diameter of particles previously defined as grits, a hollow structure in which a hollow is enclosed with a wall having numerous cracks in both inner and outer surfaces, very low contents of impurities, e.g., alkali metal elements, chlorine, radioactive substances such as uranium, Al, Fe, Ti, etc. (1 ppm or less for each impurity), and low hygroscopicity.

As the starting aqueous alkali silicate solution for obtaining the hollow fibrous silica used in the process of this invention, there can be used aqueous solutions of sodium silicate, potassium silicate, lithium silicate or the like.

The viscosity of the starting aqueous alkali silicate solution is suitably in the range of 2 to 500 poise, preferably in the range of 2 to 200 poise. When the viscosity is less than 2 poise, fiberization of the starting solution is difficult, while when it exceeds 500 poise, the stability at the time of fiberization procedure is lowered. Therefore, both of such viscosities are not desirable.

The bore diameter of the nozzle used is preferably in the range of 0.03 to 0.2 mm. When a nozzle having a bore diameter of more than 0.3 mm is used, the wall thickness of the resulting hollow fibrous silica exceeds 120 $\mu$m. Therefore, it is not desirable.

As the nozzle, a conventional nozzle having circular bores is used.

A nozzle having modified cross-section bores and a nozzle for spinning hollow fiber can also be used, but according to the process described above, hollow fibrous silica can be obtained without using a nozzle for spinning hollow fiber.

For preventing a trouble of adhesion of the alkali silicate gelatinized in the coagulating bath to the nozzle surface, the nozzle used is preferably a nozzle made of a noble metal alloy such as gold-platinum alloy, or a tetrafluoroethylene resin, or a nozzle coated on the nozzle surface with a noble metal or a tetrafluoroethylene resin.

The water-soluble organic medium as a coagulant used in the coagulating bath denotes, for example, alcohols such as methanol, ethanol, n-propanol and the like; esters such as methyl acetate, ethyl acetate and the like; ketones such as acetone, methyl ethyl ketone and the like; amides such as dimethylacetamide, dimethylformamide and the like; and dimethyl sulfoxide.

The acid as a coagulant used in the coagulating bath denotes inorganic acids such as sulfuric acid, nitric acid, hydrochloric acid and the like, and it is preferable to use sulfuric acid or nitric acid. As the acid solution, aqueous solutions of these acids are preferable for practical use.

The acid concentration of the acid solution as a coagulant used in the coagulating bath is suitably in the range of 0.1 to 4N, preferably 0.5 to 3N, more preferably 1 to 2N.

When an acid solution having an acid concentration of more than 4N is used as the coagulant, the structure of the resulting silica is too dense, so that it becomes difficult to extract and remove impurities contained in the inner part. When the acid concentration of an acid solution used as the coagulant is less than 0.1N, the coagulation rate of the alkali silicate is too slow, so that pieces of the resulting fibrous gel tend to adhere to one another. Therefore, such a concentration is not practical.

The temperature of the coagulating bath is kept suitably in the range of 25°C or higher, preferably in the range of 40° to 80°C.

When the temperature of the coagulating bath is lower than 25°C, the coagulation rate of the alkali silicate is too slow, so that it becomes difficult to obtain silica having a hollow structure.

The hollow fibrous silica having a wall thickness smaller than the diameter of particles previously defined as grits which is obtained by the process described above, is ground by means of a suitable grinding apparatus until the particles defined as grits disappear substantially.

The grinding apparatus denotes, for example, cylinder mills such as ball mill, rod mill and the like; roller mills such as edge runner, ball roller mill and the like; disc mills such as rotary crusher, attrition mill, colloid mill and the like; and impact mills such as hammer crusher, micron mill and the like. Usually, a ball mill is used.

The grinding conditions are varied depending on the kind of the grinding apparatus used, the charging amount of the starting silica, etc. and cannot be unequivocally determined, and hence the best grinding conditions are determined depending on combination of them.

The starting silica used in the process of this invention has a hollow structure in which a hollow is enclosed with a thin wall, and it has numerous cracks in the outer and inner surfaces of the wall of hollow. Therefore, its content of particles previously defined as grits can easily be adjusted to 0.5% by weight or less, if necessary 0.3% by weight or less, further 0.1% by weight or less, by a low power and a grinding treatment for a short period of time.

When a ball mill is used as the grinding apparatus, the time required for grinding in the case of using as starting silica the hollow fibrous silica used in the process of this invention can be reduced to about one half of that in the case of using silica other than the hollow fibrous silica, and according to the process of this invention, the productivity in grinding step can be greatly improved.

Moreover, silica particles having a relatively large average particle size can be obtained, and when they are used, the molding characteristics of resin at the time of encapsulating electronic parts can be improved.

According to the process of this invention, there can easily be obtained, without classification treatment, fine silica particles having an average particle size of 7 $\mu$m or more and a particle size distribution controlled so that the content of coarse particles having a particle size larger than a certain defined length is 0.5% by weight or less, if necessary 0.1% by weight or less.

Furthermore, according to the process of this invention, there is no chance of contamination of a product due to a classification procedure, and hence there can easily be obtained silica particles which have a higher purity than do those obtained by grinding conventional granular, massive silica obtained by using an aqueous alkali silicate solution as a starting material as in the present invention, a very low content of impurities, for example, alkali metal elements, chlorine, radioactive substances such as uranium, Al, Fe, Ti, etc., a low hygroscopicity, a high denseness, and a controlled particle size distribution.

The silica particles obtained by the process of this invention can be suitably used as a material for transparent vitreous silica, special ceramics and the like, and particularly as a filler for resin compositions for encapsulating electric parts.

Furthermore, the process of this invention is advantageous also in that it can reduce the manufacturing cost as compared with conventional processes.

EXAMPLES

The process of this invention is explained below with reference to Examples and Comparative Examples, in which all percents are by weight.

Example 1

Under reduced pressure, 20 Kg of aqueous sodium silicate solution #3 (corresponding to JIS K1408 Sodium Silicate No. 3: hereinafter the same applied) ($SiO_2$: 28%, $Na_2O$: 9%, U: 36 ppb) was heated at 50°C to be dehydrated and concentrated, whereby a starting solution for fiberization containing 30% $SiO_2$ was obtained. The starting solution had a viscosity of about 4 poise at 30°C.

The starting solution was filtered, after which the filtrate was extruded into a coagulating bath (an 8% aqueous sulfuric acid solution) maintained at 50°C, at a speed of 60 m/min by means of an extruder through a nozzle made of gold-platinum alloy having a bore diameter of 0.1 mm$\phi$ and a number of bores of 600.

The starting solution extruded was coagulated therein by alkali elimination to be converted into a transparent fibrous gel.

In 30 liters of a treating solution (a 10% aqueous sulfuric acid solution) was immersed 10 Kg of the fibrous gel obtained (liquid content: 200%), and treated with stirring at 100°C for 1 hour.

Subsequently, washing with 30 liters of deionized water and filtration of the silica in the form of short fibers thus obtained were repeated five times, followed by deacidification and dehydration by means of a Buchner funnel, drying overnight at 150°C, and then heat treatment at 1,200°C for 1 hour.

From observation by use of a scanning electron microscope, it was confirmed that the silica in the form of short fibers thus obtained had a hollow structure in which a hollow was enclosed with a wall having numerous cracks in both outer and inner surfaces, and that the thickness of wall of the hollow was 40 to 60 $\mu$m.

The impurity contents of this silica were as follows: Na 0.8 ppm, K < 0.1 ppm, Cl < 1 ppm, U < 1 ppb, Th < 1 ppb.

Into a ball mill (capacity 7 liters; packed with 10 Kg of 30 mm$\phi$ alumina ball) was charged 2 Kg of this silica in the form of short fibers, and subjected to grinding treatment at 60 r.p.m. for 2.5 hours. The ground product obtained had an average particle size of 19 $\mu$m, and its content of particles with a particle size of more than 74 $\mu$m defined as grits was 0.1% by weight or less.

The content of grits with a particle size of more than 74 $\mu$m was calculated from the amount of particles retained on a standard sieve Tyler No. 200.

Example 2 and Comparative Examples 1, 2 and 3

The starting solution prepared in Example 1 was treated according to the procedure of Example 1, except that it was extruded through each of a nozzle made of gold-platinum alloy having a bore diameter of 0.087 mm$\phi$ and a number of bores of 600, and those having a bore diameter of 0.3 or 0.5 mm$\phi$ and a number of bores of 100 for comparison, whereby fibrous silica having a hollow structure was obtained for each nozzle.

Each fibrous silica obtained was subjected to grinding treatment according to Example 1 for various treatment times.

The wall thickness of hollow of the starting silicas for grinding, the grinding treatment time, and the particle size of the ground products obtained are tabulated in Table 1.

When hollow fibrous silica having a wall thickness of 74 $\mu$m or less was used as a starting material for grinding, silica particles having an average particle size of 15 $\mu$m or more and a content of grits with a particle size of more than 74 $\mu$m of 0.1% by weight or less could be obtained by grinding treatment for a short period of time (Examples 1 and 2).

On the other hand, when silica which was hollow and fibrous but had a wall thickness of more than 74 $\mu$m was used as a starting material for grinding, the resulting silica particles had a high content of grits having a particle size of more than 74 $\mu$m even when grinding treatment was carried out for a longer period of time as compared with the grinding treatment in Examples (Comparative Examples 1 and 2).

In Comparative Example 1 or 2, the contents of the grits could be reduced by further prolonging the grinding treatment time or by intensifying other treatment conditions, but in this case, the average particle size was decreased to less than 7 $\mu$m, and therefore such a method is inadequate to the object of this invention (Comparative Example 3).

Table 1

| No. | | Bore diameter of nozzle, mm ( ): number of bores | Wall thickness of hollow of starting silica μm | Grinding treatment time Hr | Particle size of ground product | |
|---|---|---|---|---|---|---|
| | | | | | Average particle size μm | Grit *1 content % |
| Example | 1 | 0.1 (600) | 40 – 60 | 2.5 | 19 | < 0.1 |
| | 2 | 0.087 (600) | 25 – 40 | 1.5 | 20 | < 0.1 |
| Comparative Example | 1 | 0.3 (100) | 120 – 200 | 3.5 | 15 | 1.0 |
| | 2 | 0.5 (100) | 200 – 300 | 4.0 | 15 | 1.5 |
| | 3 | 0.3 (100) | 120 – 200 | 48 | 5 | 0.2 |

*1 ... particles having a particle size of more than 74 μm

## Examples 3 and 4 and Comparative Examples 4 and 5

The starting solution prepared in Example 1 was treated according to the procedure of Example 1, except that it was extruded through each of nozzles made of gold-platinum alloy having a bore diameter of 0.05 or 0.036 mmØ and a number of bores of 600 and that having a bore diameter of 0.3 mmØ and a number of bores of 100 for comparison, whereby fibrous silica having a hollow structure was obtained for

6

each nozzle.

Each fibrous silica obtained was subjected to grinding treatment according to Example 1 for various treatment times.

The wall thickness of hollow of the starting silicas for grinding, the grinding treatment time, and the partilcle size of the ground products obtained are tabulated in Table 2.

In the present examples and comparative examples, particles having a particle size of more than 44 $\mu$m were defined as grits, and the grit content was calculated from the amount of particles retained on a standard sieve Tyler No. 325.

When hollow fibrous silica having a wall thickness 44 $\mu$m or less was used as a starting material for grinding, silica particles having an average particle size of 7 $\mu$m or more and a content of grits with a particle size of more than 44 $\mu$m of 0.1% by weight or less could be obtained by grinding treatment for a short period of time (Examples 3 and 4).

On the other hand, when silica which was hollow and fibrous but had a wall thickness of more than 44 $\mu$m was used as a starting material for grinding, the resulting silica particles had a high content of grits having a particle size of more than 44 $\mu$m even when grinding treatment was carried out for a longer period of time as compared with the grinding treatment in Examples 3 and 4 (Comparative Examples 4 and 5). The content of the grits could be reduced by further prolonging the grinding treatment time but in this case, the average particle size became less than 7 $\mu$m (Comparative Example 5). Thus, in none of Comparative Examples 4 and 5, silica particles having a particle size aimed at by the present invention could be obtained.

Table 2

| No. | | Bore diameter of nozzle, mm ( ): number of bores | Wall thickness of hollow of starting silica μm | Grinding treatment time Hr | Particle size of ground product | |
|---|---|---|---|---|---|---|
| | | | | | Average particle size μm | Grit *2 content % |
| Example | 3 | 0.05 (600) | 20 – 30 | 2.5 | 12 | < 0.1 |
| | 4 | 0.036 (600) | 15 – 25 | 2.0 | 10 | < 0.1 |
| | 4 | 0.3 (100) | 120 – 200 | 7.0 | 12 | 2.0 |
| Comparative Example | 5 | 0.3 (100) | 120 – 200 | 48 | 5 | 0.5 |

*2 ··· particles having a particle size of more than 44 μm

The impurity contents of the fine silica particles after grinding obtained in all the examples were as follows: Na 1.0 ppm, K 0.2 ppm, Cl < 1 ppm, U < 1 ppb, Th < 1 ppb.

**Claims**

1. A process for preparing fine silica particles having an average particle size of 7-20 μm and containing 0.5 % by weight or less of coarse particles having a particle size of more than 74 μm by performing a

8

grinding step by the use of hollow silica fibres having a wall thickness smaller than 74 $\mu$m as the starting material.

2. A process according to claim 1, wherein said length is 74 $\mu$m or more and said step of grinding is carried out, so that the average particle size of the fine silica particles is in a range of 15 to 20 $\mu$m.

3. A process according to claim 1, wherein said length is more than 44 $\mu$m and said step of grinding is carried out, so that said average particle size of the fine silica particles is in the range of 10 to 12 $\mu$m.

4. A process according to any one of the claims 1 to 3, wherein the hollow silica fibers are obtained by the following method (1) or (2):
   (1) a method which comprises
   extruding an aqueous solution of an alkali silicate represented by the general formula:

   $M_2O \times nSiO_2$

   wherein M is an alkali metal element and n is a number of moles of $SiO_2$ of 0.5 to 5, into a coagulating bath comprising a water-soluble organic medium or an acid solution having a concentration of 4N or less through a nozzle having a bore diameter of 0.2 mm or less to coagulate the same in fibrous form; said aqueous solution having a viscosity in the range of 2 to 500 poise,
   treating the thus obtained fibrous gel with an acid-containing solution, and
   then washing the same with water to extract and remove impurities;
   (2) a method which comprises further heat-treating the silica obtained by the method of (1) above at a temperature of 1,000 °C or higher.

5. A process for manufacturing fine silica particles according to claim 1, wherein said hollow silica fibres have cracks on the surface of their walls.

**Patentansprüche**

1. Ein Verfahren zur Herstellung feiner Siliciumdioxidteilchen, welche eine durchschnittliche Teilchengröße von 7 bis 20 $\mu$m haben und $\leq$ 0,5 Gew.-% grobe Teilchen mit einer Teilchengröße von mehr als 74 $\mu$m enthalten, wobei ein Mahlschritt unter Verwendung von hohlen Siliciumdioxidfasern als Ausgangsmaterial durchgeführt wird, welche eine Wandstärke von $\leq$ 74 $\mu$m haben.

2. Ein Verfahren entsprechend Anspruch 1, wobei die genannte Länge $\geq$ 74 $\mu$m ist, und der genannte Mahlschritt in der Weise durchgeführt wird, daß die durchschnittliche Teilchengröße der feinen Siliciumdioxidteilchen im Bereich von 15 bis 20 $\mu$m liegt.

3. Ein Verfahren gemäß Anspruch 1, wobei die genannte Länge mehr als 44 $\mu$m ist und der genannte Mahlschritt in der Weise durchgeführt wird, daß die genannte durchschnittliche Teilchengröße der feinen Siliciumdioxidteilchen im Bereich von 10 bis 12 $\mu$m liegt.

4. Ein Verfahren gemäß irgendeinem der Ansprüche 1 bis 3, wobei die hohlen Siliciumdioxidfasern mittels der folgenden Methode (1) oder (2) erhalten werden:
   (1) ein Verfahren, welches einschließt
   das Extrudieren einer wässrigen Lösung eines Alkalisilikats, welches dargestellt wird durch die allgemeine Formel:

   $M_2O \times nSiO_2$ ,

   wobei M ein Alkalimetallelement und n eine Anzahl von Molen von $SiO_2$ von 0,5 bis 5 ist, durch eine Düse mit einem Bohrdurchmesser von < 0,2 mm in ein Koagulationsbad, das ein wasserlösliches organisches Medium oder eine Säurelösung enthält, deren Konzentration < 4 normal ist, um die wässrige Lösung faserförmig zu koagulieren, wobei diese eine Viskosität im Bereich von 2 bis 500 Poise hat,
   das Behandeln des so erhaltenen faserförmigen Gels mit einer säurehaltigen Lösung und
   das Waschen desselben, um Verunreinigungen zu extrahieren und zu entfernen,

(2) ein Verfahren, welches weiterhin die Hitzebehandlung des mittels des obigen Verfahrens (1) erhaltenen Siliciumdioxids bei einer Temperatur von > 1000 °C einschließt.

5. Ein Verfahren zur Herstellung feiner Siliciumdioxidteilchen entsprechen Anspruch 1, wobei die genannten hohlen Siliciumdioxidfasern auf der Oberfläche ihrer Wände Sprünge haben.

**Revendications**

1. Procédé pour la préparation de particules de silice fines d'une granulométrie moyenne de 7-20 microns et contenant 0,5% en poids ou moins de particules brutes ayant une granulométrie supérieure à 74 microns en effectuant une étape de broyage en utilisant des fibres de silice creuses d'une épaisseur de paroi inférieure à 74 microns en tant que matière de départ.

2. Procédé selon la revendication 1, dans lequel la longueur est de 74 microns ou d'avantage et l'étape de broyage est effectuée de telle sorte que la granulométrie moyenne des particules de silice fines se situe dans une plage de 15 à 20 microns.

3. Procédé selon la revendication 1, dans lequel la longueur est supérieure à 44 microns et l'étape de broyage s'effectue de telle sorte que la granulométrie moyenne des particules de silice fines se situe dans la plage de 10 à 12 microns.

4. Procédé selon l'une quelconque des revendications 1 à 3, dans lequel les fibres de silice creuses sont obtenues par le procédé suivant (1) ou (2) :
   (1) un procédé qui comprend l'étape consistant à extruder une solution aqueuse d'un silicate alcalin représenté par la formule générale :

   $M_2O \times nSiO_2$

   dans laquelle M est un élément des métaux alcalins et n est un nombre de moles de $SiO_2$ de 0,5 à 5, dans un bain de coagulation comprenant un milieu organique hydrosoluble ou une solution acide ayant une concentration de 4N ou moins par une tuyère ayant un diamètre d'alésage de 0,2 mm ou moins pour coaguler celle-ci sous la forme fibreuse; la solution aqueuse ayant une viscosité dans la plage de 2 à 500 poises,
   traiter le gel fibreux ainsi obtenu avec une solution contenant un acide, et
   laver ensuite celle-ci à l'eau pour extraire et enlever les impuretés ;
   (2) un procédé qui comprend de plus le traitement thermique de la silice obtenue par le procédé de (1) ci-dessus à une température de 1.000 °C ou supérieure.

5. Procédé pour la fabrication de particules de silice fines selon la revendication 1, dans lequel les fibres de silice creuses présentent des fissures à la surface de leurs parois.